(19) Europäisches Patentamt
European Patent Office
Office européen des brevets

(11) **EP 4 001 455 A1**

(12) **EUROPEAN PATENT APPLICATION**

(43) Date of publication:
**25.05.2022 Bulletin 2022/21**

(21) Application number: **20208461.2**

(22) Date of filing: **18.11.2020**

(51) International Patent Classification (IPC):
*C23C 16/04* (2006.01)    *C23C 16/48* (2006.01)
*G03F 7/004* (2006.01)    *G03F 7/16* (2006.01)
*H01L 21/02* (2006.01)    *H01L 21/027* (2006.01)
*H01L 29/739* (2006.01)

(52) Cooperative Patent Classification (CPC):
**C23C 16/483; C23C 16/047; G03F 7/0042;
G03F 7/165; G03F 7/167; H01L 21/02381;
H01L 21/02425; H01L 21/02488; H01L 21/02505;
H01L 21/02521; H01L 21/02527; H01L 21/0254;
H01L 21/02568; H01L 21/0259; H01L 21/02636;**
(Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **PARAYIL VENUGOPALAN, Syam
5500 AH Veldhoven (NL)**
• **KURGANOVA, Evgenia
5500 AH Veldhoven (NL)**
• **FARAMARZI, Vina
5500 AH Veldhoven (NL)**

(74) Representative: **ASML Netherlands B.V.
Corporate Intellectual Property
P.O. Box 324
5500 AH Veldhoven (NL)**

(54) **METHOD OF FORMING A PATTERNED LAYER OF MATERIAL**

(57)    Methods of forming a patterned layer of material are disclosed. In one arrangement, a substrate having a layered structure is provided. The layered structure comprises a base layer, a support layer, and a thermally insulating layer. The support layer comprises a plurality of sub-units that are thermally insulated from each other. A selected portion of the support layer is selectively irradiated during a deposition process. The irradiation locally drives the deposition process to form a layer of deposited material in a pattern defined by the selected portion.

Fig. 11

**(Cont. next page)**

(52) Cooperative Patent Classification (CPC): (Cont.)
**H01L 29/7391**

**Description**

FIELD

The present invention relates to methods of forming a patterned layer of material.

BACKGROUND

As semiconductor manufacturing processes continue to advance, the dimensions of circuit elements have continually been reduced while the amount of functional elements, such as transistors, per device has been steadily increasing, following a trend commonly referred to as 'Moore's law'. To keep up with Moore's law the semiconductor industry is seeking technologies that enable creation of increasingly smaller features.

For some types of electronic device, scaling down of the device features can cause performance challenges, such as the short-channel effect that occurs in MOSFETs when the channel length becomes comparable to the depletion layer widths of the source and drain junctions. These challenges can sometimes be addressed using two-dimensional materials, which are atomically thin and can have relatively low dielectric constants.

Various deposition technologies exist for fabricating two-dimensional materials. Such deposition technologies include chemical vapor deposition (CVD), mechanical cleaving (exfoliation), molecular beam epitaxy (MBE), atomic layer deposition (ALD), liquid-phase exfoliation, and others. A challenge with many of these deposition technologies has been the high temperatures that are required for the processes to work efficiently (with high speed and quality). High temperatures can degrade or damage previously deposited layers and/or restrict the range of previously deposited layers that can be used. The previously deposited layers must be formed so that they can withstand the high temperatures to an acceptable degree, for example by having melting points above the temperatures reached during the deposition process.

In approaches based on exfoliation, the two-dimensional material can be grown offline without restrictions on temperature, but it is difficult to perform the exfoliation and transfer process with high throughput and low defectivity.

Patterning two-dimensional materials presents further challenges due to their fragile nature. The two-dimensional materials can be damaged by traditional patterning processes such as resist coating, lithography, etch and resist stripping.

SUMMARY

It is an object of the invention to provide alternative or improved methods for forming patterned layers.

According to an aspect, there is provided a method of forming a patterned layer of material, comprising: providing a substrate having a layered structure, the layered structure comprising a base layer, a support layer, and a thermally insulating layer, wherein: the thermally insulating layer has a lower thermal conductivity than the support layer; the support layer comprises a plurality of sub-units that are thermally insulated from each other within a plane of the support layer; and the method comprises selectively irradiating a selected portion of the support layer during a deposition process, the irradiation being such as to locally drive the deposition process in the selected portion and thereby form a layer of deposited material in a pattern defined by the selected portion.

Thus, a method is provided in which a patterned layer of material can be formed without using a resist. This approach provides flexibility and processing efficiency. The approach is particularly suitable for deposition of two-dimensional materials for electronic devices, which may be vulnerable to damage during alternative resist-based processing. The method also allows two-dimensional materials to be grown in-situ, which reduces the risk of damage and processing complexity associated with transferring two-dimensional material between different locations (e.g. during exfoliation-based alternatives). The combination of the thermally insulating layer and the support layer segmented into thermally insulated sub-units reduces the rate of dissipation of heat from the selective irradiation away from the support layer. The combination thus increases a local temperature rise associated with the selective irradiation. The increased local temperature increases a growth rate and crystalline quality of material deposited by the deposition process. The local nature of the temperature increase reduces or avoids the risk of damage to underlying layers. Increasing the speed of deposition increases throughput.

In some embodiments, the thermally insulating layer comprises a multilayer stack comprising layers of two-dimensional material. At least two adjacent layers of two-dimensional material in the thermally insulating layer may have different compositions relative to each other. Providing two-dimensional materials having different compositions to surrounding layers provides lattice and/or mass density mismatches that reduce phonon transmission, thereby improving heat retention in the support layer.

In some embodiments, the sub-units are provided in a sub-unit pattern that is in spatial registration with the pattern defined by the irradiated selected portion. Each sub-unit can then represent a thermally isolated structure that can be processed separately from other sub-units by the selective irradiation. For example, the pattern of deposited material may comprise a plurality of isolated portions of deposited material, each isolated portion being provided on a different one of the sub-units. The isolated portions of deposited material may, for example, form channels of electronic devices, such as channels of 2D-FETs. Alternatively or additionally, the isolated portions of deposited material may form interconnects comprising deposited two-dimensional material in a trench.

In some embodiments, the method further comprises applying a supplementary irradiation to increase a temperature of the support layer during the selective irradiation of the selected portion. The supplementary irradiation may have a spatial resolution that is less fine than the selective irradiation. The supplementary irradiation may comprise a flood exposure. The supplementary irradiation may raise the overall average temperature of the support layer such that the temperature increase that needs to be achieved by the selective irradiation is not as high as it would be otherwise. Furthermore, the supplementary irradiation may decrease a temperature difference between the selected portion and surrounding regions thereby reducing the rate of heat conduction away from the selected portion.

BRIEF DESCRIPTION OF THE DRAWINGS

Embodiments of the invention will now be described, by way of example only, with reference to the accompanying schematic drawings, in which:

Figure 1 depicts a first example of a lithographic system comprising a lithographic apparatus and a radiation source;
Figure 2 depicts a second example of a lithographic system comprising a lithographic apparatus and a radiation source;
Figure 3 schematically depicts the path of an EUV exposure region/slit over a substrate;
Figure 4 is a graph showing an expected exponential relationship between the lateral growth rate of two-dimensional material on a substrate and the temperature of the substrate;
Figure 5 is a graph showing a linear variation of lateral growth time as a function of substrate temperature;
Figure 6 is a schematic side sectional view of a portion of a substrate having a layered structure with base layer, thermally insulating layer, and segmented support layer;
Figure 7 schematically depicts irradiation of a selected portion on a substrate during a first step of an atomic layer deposition process;
Figure 8 schematically depicts a step in the atomic layer deposition process after the step depicted in Figure 7;
Figure 9 schematically depicts a lithographic apparatus providing radiation to an environment control system;
Figure 10 schematically depicts an apparatus for forming a patterned layer of material comprising radiation systems configured to irradiate the substrate from opposite sides;
Figure 11 schematically depicts an apparatus for forming a patterned layer of material comprising an EUV lithographic apparatus and an e-beam source;
Figures 12-16 are schematic side sectional views of a portion of a substrate depicting stages in a first example process flow for forming a 2D-FET;
Figures 17-21 are schematic side sectional views of a portion of a substrate depicting stages in a second example process flow for forming a 2D-FET;
Figures 22-26 are schematic side sectional views of a portion of a substrate depicting stages in a third example process flow for forming a 2D-FET.

DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm), as well as electron beam radiation.

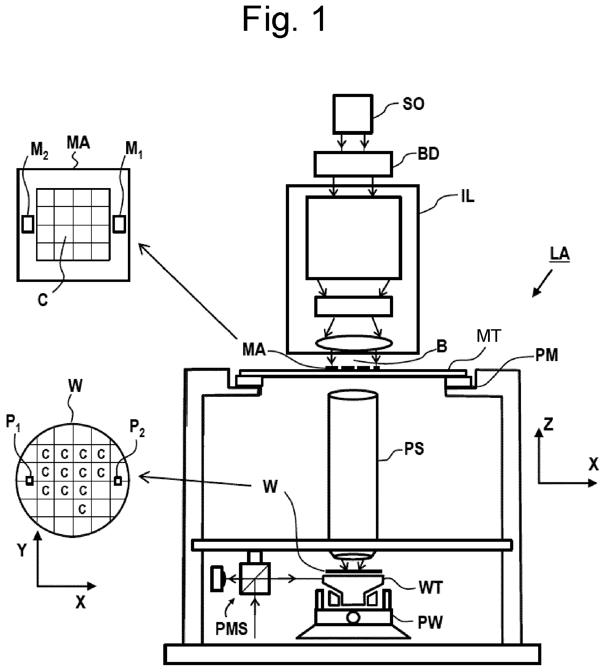

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

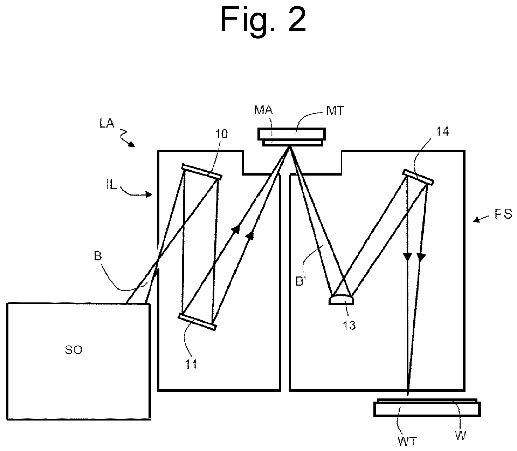

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As mentioned in the introductory part of the description, although there is interest in using two-dimensional materials in semiconductor manufacturing process, there are challenges in achieving sufficiently high crystalline quality and/or throughput and/or low defectivity. Deposition processes such as CVD and ALD require high temperatures, which can damage underlying layers. For example, typical CVD processes for producing high quality monolayers of two-dimensional crystals can require temperatures higher than 800°C, whereas temperatures above 500°C are typically incompatible with back end of the line CMOS technology. The thermal budget for Si FinFets (fin field-effect transistors), for example, is less than 1050°C for front end of the line (FEOL) and less than 400°C for back end of the line (BEOL). For 2D-FETs (field-effect transistors based on two-dimensional materials) this budget is much lower (typically 450-500°C for both FEOL and BEOL). Exfoliation-based processes avoid these thermal constraints because the deposition of the two-dimensional material can be performed at a separate location, but the transfer process is complex and it is difficult to avoid high defectivity. Traditional patterning processes such as resist coating, lithography, etch and resist stripping are also problematic because they can damage two-dimensional materials. Moreover, conventional lithography techniques represent a challenge for patterning 2D material layers. Due to the nature of these materials, the resulting structures are contaminated and/or damaged with rough edges after a lithography (DUV, EUV, EBL) followed by (dry-, wet-) etch step. Contacts to other layers e.g. source and drain electrodes are not optimal, resulting in a ~ 3.5 times larger Schottky barrier compared to where clean and sharp interfaces are provided.

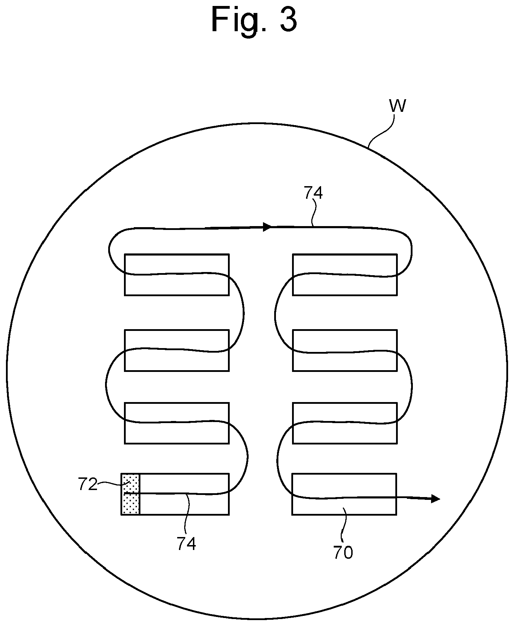

An alternative approach using EUV-induced deposition can form patterns of two-dimensional material directly, without any resist processing. Examples of such deposition are described in WO2019166318, WO2020207759 and in EP patent application 20160615.9, all hereby incorporated in their entirety by reference. It can be difficult, however, with EUV-induced deposition to achieve sufficiently high growth rates of two-dimensional material. The EUV dose (the amount of energy deposited per unit area by the EUV radiation) is constrained in practice to be below a predetermined EUV dose limit to avoid damage to the surface being irradiated and/or underlying layers. A typical EUV dose limit may be 100 mJ/cm$^2$ for example. Referring to Figure 3, a maximum EUV exposure time corresponding to the EUV dose limit can calculated. Figure 3 depicts a path 74 of an EUV exposure region 72 (slit) of an EUV projection apparatus over a substrate W to form patterned fields 70. The following example configuration achieves an EUV dose of 20mJ/cm$^2$: slit velocity = 330mm/s; slit dimensions = 26mm x 3mm; field dimensions = 26mm x 33mm; exposure time per field = (33 + 3)/330; exposure time per pattern = approx. 9ms. The maximum exposure time per pattern, corresponding to the EUV dose limit of 100 mJ/cm$^2$, would therefore be approximately 45ms.

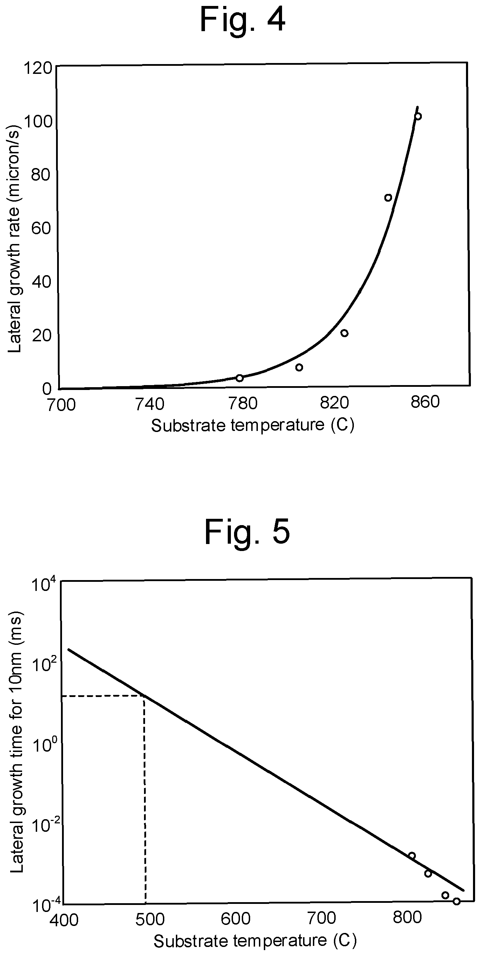

Figure 4 is a graph showing an expected exponential relationship between the lateral growth rate of two-dimensional material on a substrate and the temperature of the substrate. Figure 5 is a graph showing a linear variation of the time for a lateral growth of 10nm against the substrate temperature. The data points in Figures 4 and 5 are derived from Zhengwei Zhang, Peng Chen, Xiangdong Yang, Yuan Liu, Huifang Ma, Jia Li, Bei Zhao, Jun Luo, Xidong Duan, Xiangfeng Duan, Ultrafast growth of large single crystals of monolayer WS2 and WSe2, National Science Review, Volume 7, Issue 4, April 2020, Pages 737-744. The broken lines in Figure 5 indicate that to achieve a lateral growth of 10nm during the 45ms of exposure time available the substrate temperature needs to be at least 500°C. However, for an EUV exposure on a 100nm$^2$ area (corresponding to 10nm lateral growth) with a dose of 100mJ/cm$^2$, the corresponding temperature rise, $T_{rise}$, on a 30 nm In$_2$O$_3$ substrate is expected to be only about $1.6 \times 10^{-11}$ K:

$$T_{rise} = \frac{\text{dose} \times \text{area exposed} \times \text{Photon absorption ratio}}{\text{depth} \times \text{area} \times \text{density} \times \text{specific heat}}$$

$$= \frac{100 \text{ mJcm}^{-2} \times 1 \times 10^{-12} \text{cm}^2 \times 0.85}{0.3 \times 10^{-5} \text{cm} \times 3.14 \times 15^2 \text{cm}^2 \times 7.18 \text{ gcm}^{-3} \times 343 \text{mJ/gK}}$$

$$= 1.6 \times 10^{-11} \text{ K}$$

Embodiments of the present disclosure provide methods of forming a patterned layer of material that use adaptations in the structure of the substrate to better retain energy from irradiation, leading to a larger temperature rise and improved deposition rate.

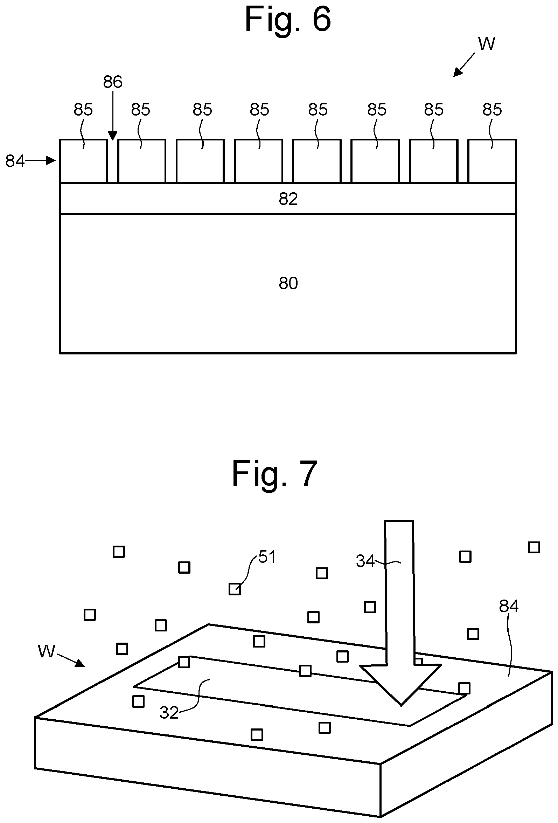

The methods may be applied to a substrate W having a layered structure, as exemplified in Figure 6. Figure 6 depicts only a portion of the substrate W and dimensions have been exaggerated for clarity. The layered structure comprises a plurality of layers arranged one on top of the other. The layered structure may be referred to as a stack. Each of the layers may be continuous or patterned. In an embodiment, the layered structure comprises a base layer 80, a support layer 84 and a thermally insulating layer 82. The thermally insulating layer 82 has a lower thermal conductivity (e.g. averaged over the volume of the thermally insulating layer 82) than the support layer 84. The thermally insulating layer 82 may additionally have a lower thermal conductivity than the base layer 80 (and/or, in embodiments with further layers, than one of more other layers beneath the support layer 84). The thermally insulating layer 82 thus slows a rate of heat flow from the support layer 84 into layers beneath the support layer 84. The base layer 80 may comprise a silicon substrate (silicon wafer) for example. The support layer 84 may comprise any material on which it is desired to form a two-dimensional material as a step in a manufacturing process (e.g. of an electronic device such as a 2D-FET). The support layer 84 may comprise one or more of the following: $Al_2O_3$; $SiO_2$; $HfO_2$; Sn; $SnO_2$; $In_2O_3$; Indium Tin Oxide (ITO). The support layer 84 may particularly preferably comprise one or more of Sn; $SnO_2$; $In_2O_3$; ITO.

The thermal insulating layer 82 may comprise a homogeneous layer formed from a material having low thermal conductivity. The thermal resistance provided by the homogeneous layer depends on the thickness of the layer. Increasing the thickness of the layer will increase the thermal resistance. In some embodiments, the thermally insulating layer 82 comprises a multi-layer stack comprising layers of two-dimensional material. At least two adjacent layers of two-dimensional material may have different compositions relative to each other. The different compositions provide lattice and/or mass density mismatches which reduce phonon transmission and hence reduce thermal conductivity. Thermal conductivities as low as 0.007W/mK have been reported in the literature using such multi-layer stacks. As the thermally insulating layer 82 may separate the bottom gate dielectric from the device layer 94 a thinner thermally insulating layer 82 may also promote effective electrostatic control by the gate over the device. The thickness of individual layers may also be important in 3D integration where several layers of a transistor are stacked vertically. In some embodiments, the layers of two-dimensional material comprise one or more layers of the following: graphene; $WSe_2$; $MoS_2$; α-selenene; α-tellurene. These two-dimensional materials can be deposited relatively straightforwardly because they do not need to be provided in patterned form. The layers can be uniformly deposited in a uniform layer. Moreover, these layers of two-dimensional material do not need to be defect free and can be deposited using conventional (low temperature) CVD/ALD techniques. Ultralow thermal conductivity can be obtained using a stack of heterogenous materials to impede heat flow perpendicular to the interfaces. However, when packed within a distance comparable to the phonon wavelengths, these interfaces are coupled and thus ineffective to scatter low-energy phonons, due to either coherent phonon transmission across the closely packed interfaces or weak coupling of the low-energy phonons and the interfaces. Following the work of Zheng et. al. (Ultralow Thermal Conductivity and Thermal Diffusivity of Graphene/Metal Heterostructures through Scarcity of Low-Energy Modes in Graphene; Weidong Zheng, Bin Huang, and Yee Kan Koh; ACS Applied Materials & Interfaces 2020 12 (8), 9572-9579; DOI: 10.1021/acsami.9b18290), the propagation of these low-energy phonons can be blocked by periodically distributed scarcity of available low-energy phonon modes using graphene/metal heterostructures of transferred graphene and ultrathin metal films.

The support layer 84 may be adapted to limit lateral spreading of energy from the irradiation. The combination of the adapted support layer 84 and the thermally insulating layer 82 thus slow loss of heat both downwards through layers below the support layer 84 and laterally within the support layer 84 itself. In some embodiments, the support layer 84 is configured to comprise a plurality of sub-units 85. Each sub-unit 85 is thermally insulated from each other sub-unit 85 within a plane of the support layer 84 (i.e. with the main plane of the support layer 84, which would be horizontal and extending vertically out of the page in the orientation of Figure 6). The thermal resistance between neighbouring sub-units 85 is thus higher than would be the case without the thermal insulation 86 (e.g. in the case where the support layer was a uniform unpatterned layer). The thermal insulation between the sub-units 85 may be achieved in a manufacturing process that involves cutting through a previously uniform unpatterned layer in a pattern that defines the sub-units 85.

As a demonstration of principle, the temperature rise $T_{rise}$ in a support layer 84 made of $In_2O_3$ segmented into sub-units 85 having dimensions of $30 \times 30 \times 30$ nm$^3$ can be calculated approximately as follows (assuming for demonstration purposes perfect insulation by an underlying thermally insulating layer):

$$T_{rise} = \frac{100\,\text{mJcm}^{-2} \times 1 \times 10^{-12}\,\text{cm}^2 \times 0.85}{\left(0.3 \times 10^{-5}\,\text{cm} \times 9 \times 10^{-12}\,\text{cm}^2 \times 7.18\,\text{gcm}^{-3} \times \frac{343\,\text{mJ}}{\text{gK}}\right)} = 1278\,\text{K}$$

$T_{rise}$ is the temperature rise over room temperature, so the actual temperature of the support layer 84 would be approximately 1278 + 300 = 1578 K. The temperature rise can be further increased by choosing a support layer 84 having lower thermal diffusivity and/or a higher (finer) segmentation. Some thermal leakage through the thermally insulating layer 82 will occur in practice, but this will not be extensive enough to prevent significant improvements in the speed of growth of two-dimensional material.

The surface temperature for various levels of thermal leakage through the thermally insulating layer 82 can be calculated by solving the partial differential equation

$$\frac{\partial T}{\partial t} = \alpha \frac{\partial^2 T}{\partial z^2}$$

with the heat flux $q$ through a top surface of the support layer 84 being given as

$$q = \frac{\text{dose} \times \text{photon absorption ratio}}{\text{expose time}} = -k \frac{\partial T}{\partial z}$$

with $z$ representing a vertical direction perpendicular to the plane of the substrate W. For a dose of 100mJcm$^{-2}$ and an exposure time of 45ms, it is found that surface temperatures for a segmented support layer 84 can rise up to 1578 K for a perfectly insulating thermally insulating layer 82 and up to 780 K for 50% insulation. Temperatures can thus be achieved that support highly efficient radiation-induced deposition in many scenarios.

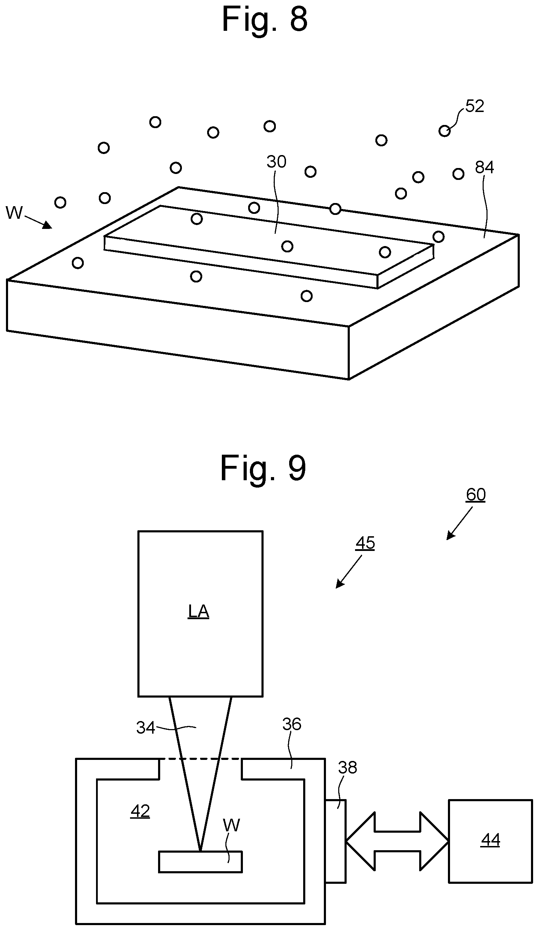

Methods may thus be provided that apply radiation-induced deposition to substrates of the type described above with reference to Figure 6. Exemplary approaches are described below with reference to Figures 7 and 8.

In some embodiments, the support layer 84 is irradiated during a deposition process to form a patterned layer of material 30. As depicted in Figure 7, the method comprises selectively irradiating 34 a selected portion 32 of the support layer 84 during the deposition process. The irradiation may thus be applied only in the selected portion 32 and not elsewhere on the support layer 84. In an embodiment, the patterned layer comprises, consists essentially of, or consists of, a two-dimensional material. A two-dimensional material is a material that shows significant anisotropy of properties in lateral directions within a plane of the material compared to the direction perpendicular to the plane of the material. A class of two-dimensional materials are sometimes referred to as single-layer materials, or monolayers, and may comprise crystalline materials consisting of a single layer of atoms or a small number of single layers of atoms on top of each other. In some embodiments, the two-dimensional material comprises, consists essentially of, or consists of, one or more of the following: one or more 2D allotropes such as graphene and antimonene; one or more inorganic compounds such as MXenes, hexagonal boron nitride (hBN), and a transition metal dichalcogenide (TMD) (a semiconductor of the type $MX_2$, which may be atomically thin, with the letter M referring to a transition metal atom (e.g. Mo or W) and the letter X referring to a chalcogen atom (e.g. S, Se, or Te)), for example $WS_2$, $MoS_2$, $WSe_2$, $MoSe_2$, etc. The two-dimensional material may comprise a layer of M atoms sandwiched between two layers of X atoms. The two-dimensional material may comprise any semiconductor two-dimensional material suitable for use as a transistor channel. As mentioned above, the two-dimensional material may compromise a 2D allotrope e.g. graphene or antimonene, or an inorganic compound. The two-dimensional material may comprise a monolayer (or multiple monolayers if the deposition process is repeated). In the embodiment shown, the deposition process is an atomic layer deposition process. In other embodiments, a different deposition process or combination of deposition processes is used, including for example one or more of the following independently or in combination: atomic layer deposition; chemical vapor deposition; plasma-enhanced chemical vapor deposition; epitaxy; sputtering; and electron beam-induced deposition. The formation of the patterned layer of material 30 may constitute a step in a method of forming at least one layer of a device to be manufactured, such as a semiconductor device. The two-dimensional material may, for example, form a channel of an FET or a metal cap or diffusion barrier in an interconnect.

In an embodiment, the irradiation is performed with radiation that is capable of locally driving the deposition process. In an embodiment, the radiation comprises, consists essentially of, or consists of any type of EUV radiation (having a wavelength less than 100nm) that is capable of locally driving the deposition process. The use of EUV radiation provides high spatial resolution. In some other embodiments, the irradiation is performed with radiation comprising, consisting essentially of, or consisting of, higher wavelength radiation, optionally in combination with an immersion liquid, as described below. The higher wavelength radiation may be in the range of 100nm to 400nm (including DUV radiation).

The irradiation locally drives the deposition process in the selected portion 32 and thereby causes the formation of a layer of deposited material 30 (see Figure 8) in a pattern defined by the selected portion 32. A pattern is thus formed without needing any resist. No processing to remove a resist is therefore required, which reduces the risk of damage to the patterned layer of material 30 or to any fragile underlying materials. This approach is particularly desirable where resist residue could significantly impact properties of a fragile underlying material and/or where lift-off of resist could significantly damage a fragile underlying material. Examples of fragile underlying materials include very thin film coatings, 2D materials such as graphene or transitional metal dichalcogenides (TMD), and free-standing membranes or thin films. In contrast to traditional lithography-based semiconductor manufacturing processes, instead of being used to break or cross-link molecules in a resist, radiation is being used to drive one or more chemical reactions involved in the deposition process.

Atomic layer deposition is a known thin-film deposition technique in which each of at least two chemicals (which may be referred to as precursor materials) are made to react with the surface of a material in a sequential, self-limiting, manner. In contrast to chemical vapor deposition, the two precursor materials are not normally present simultaneously above the substrate W.

In at least some embodiments using atomic layer deposition, the atomic layer deposition comprises at least a first step and a second step. In the first step, an example of which is depicted in Figure 7, a first precursor material 51 is made to react with a surface of a substrate W. In the second step, an example of which is depicted in Figure 8, a second precursor material 52 is made to react with the substrate W in a region where the first precursor 51 reacted with the substrate W in the first step (in this example the selected portions 32).

Figure 9 schematically depicts an apparatus 60 for performing the method. The apparatus 60 thus forms a patterned layer of material. The apparatus 60 comprises an irradiation system. The irradiation system may comprise a lithographic apparatus LA. The lithographic apparatus LA irradiates the selected portion 32 by projecting a patterned radiation beam from a patterning device MA onto the substrate W. The lithographic apparatus LA may be configured as described above with reference to Figure 1 (e.g. when the irradiation comprises DUV radiation and/or immersion lithography is required) or as described above with reference to Figure 2 (e.g. when the irradiation comprises EUV radiation).

In an embodiment, the lithographic apparatus LA is configured to perform immersion lithography. In such an embodiment, the atomic layer deposition process may comprise a step in which the selected portion 32 is irradiated while the selected portion 32 is in contact with an immersion liquid. Thus, for example, the atomic layer deposition process may comprise a first step comprising adsorption of a precursor from a gaseous precursor material to the substrate W and a second step in which the adsorbed precursor is modified in the selected portion 32 (e.g. to remove a by-product of the adsorption process) by irradiation through the immersion liquid. Any by-product produced by the irradiation through the immersion liquid can conveniently be carried away by flow of the immersion liquid. In an embodiment, the irradiated substrate W is subsequently dried and any further required processing is performed on the dried substrate W.

In an embodiment, an environment control system 45 is provided. The environment control system 45 allows the composition of the environment 42 above the substrate W to be controlled in such a way as to allow the deposition process to proceed. In an embodiment, the environment control system 45 comprises a chamber 36 to provide a sealed environment 42 including the selected portion 32 of the support layer on the substrate W. In some embodiments, all of the substrate W will be within the chamber 36 during the deposition process (e.g. atomic deposition process). In an embodiment, a materials exchange system 38 (e.g. a port into the chamber 36 and associated valves and/or conduits) is provided that allows materials to be added to and removed from the sealed environment 42 to allow different compositional environments to be established within the sealed environment 42. Materials may be provided to and from the materials exchange system 38 by a flow manager 44. The flow manager 44 may comprise any suitable combination of reservoirs, ducting, valves, sinks, pumps, control systems, and/or other components necessary to provide the required flows of materials into and out of the chamber 36. The different compositional environments achieved in this way may correspond to different respective stages of the deposition process. In some embodiments, the materials added to and removed from the chamber 36 are gaseous, thereby providing compositional environments consisting of different combinations of gases. In an embodiment in which one or more steps of the deposition process are performed by irradiating the substrate W through an immersion liquid, the environment control system 45 may be configured to allow switching between a state in which a controlled liquid environment is maintained above the substrate W (e.g. during exposure in an immersion lithography mode) and a state in which a controlled gaseous environment is maintained above the substrate W (e.g. during adsorption of a precursor from a gaseous precursor material).

In some embodiments, the driving of the deposition process in the selected portion 32 comprises driving a chemical reaction involving a precursor material. The precursor material will be provided as part of the compositional environment established above the substrate during the irradiation. The driving of the chemical reaction may cause the chemical reaction to proceed at a faster rate than would be the case in the absence of the irradiation. Alternatively, the chemical reaction may be such that it would not occur at all in the absence of the irradiation. In an embodiment, the chemical reaction is endothermic, and the irradiation provides the energy necessary to allow the chemical reaction to proceed. In some embodiments, the chemical reaction is at least partially driven by heat generated in the substrate W by the irradiation. Thus, the chemical reaction being driven by the irradiation may comprise a chemical reaction that requires an elevated temperature to proceed or which proceeds more rapidly at elevated temperatures. In some embodiments, the chemical reaction comprises a photochemical reaction driven by the irradiation. Thus, at least one species involved in the chemical reaction directly absorbs a photon from the irradiation and the absorption of the photon allows the chemical reaction to proceed. In some embodiments, the photochemical reaction comprises a multi-photon photochemical reaction involving absorption of two or more photons by each of at least one species involved in the photochemical reaction. The requirement for two or more photons to be absorbed makes the chemical reaction much more sensitive to variations in the intensity of the irradiation (i.e. the rate of the chemical reaction varies much more strongly as a function of intensity) than would be the case for single photon photochemical reactions. The increased sensitivity to intensity provides improved lateral contrast. In an embodiment, a combination of a photochemical reaction and radiation induced heating is used to provide a well-defined process window in which the chemical reaction is driven locally to produce the pattern. In an embodiment, the chemical reaction is driven by a plasma generated by interaction between the radiation and the substrate W, a layer formed on the substrate W, and/or a gas present above the substrate. In an embodiment, the generated plasma is generated in a localized region defined by the irradiation. In an embodiment, the chemical reaction is driven by electrons provided by the irradiation. The electrons may comprise photoelectrons or secondary electrons (electrons generated by inelastic scattering events of a photoelectron or of electrons from an e-beam). In an embodiment, photons absorbed by the substrate W may provide energetic electrons near the surface of the substrate W that participate in the deposition process. In embodiments where a combination of electromagnetic radiation and an e-beam is used, a portion of the deposition process may be driven by electrons from the e-beam.

In some embodiments, flow dynamics of gaseous/liquid co-reactants and/or catalysts and/or precursors are controlled during the deposition process. The control of the flow dynamics can improve the quality of material deposited. The control of flow dynamics may include controlling a direction of the flow (or a vector flow field of the flow). Alternatively or additionally the control of flow dynamics may include controlling a rate of the flow, including for example providing a pulsed flow. In an embodiment, the control of flow dynamics is performed so as to create locally in space and/or time a high density of relevant particles near the deposition location and a low density of the particles near other surfaces (e.g. optics).

In some embodiments, the compositional environment is controlled to provide different mixtures of gases at different times. The different mixtures of gases may be provided to deposit different materials or to switch between a mode where material is deposited and a mode in which material is etched away. The different mixtures of gases may also be used to controllably vary a rate of deposition as a function of time, which may be useful for example to create features with well-defined edges and/or shapes.

In some embodiments, a charging balance is controlled during the deposition process using pre-charging and/or continuous charging. The pre-charging and/or continuous charging may be provided for example using an electron flood gun or by a photoemission mechanism (e.g. using a laser).

Low-energy electrons (like secondary or backscatter electrons escaping from a substrate-vacuum interface) can induce chemical reactions with molecules on or above a substrate surface. The reaction rates depend on the number and energy of the low-energy electrons present. For nonconducting materials the emission of electrons from the substrate (e.g. by EUV irradiation) causes positive charging of the substrate W. This charging influences the electron yield from the substrate W and the trajectories and energies of electrons leaving the substrate W. The charging thus influences the electron density on or above the substrate surface and can be used to control reaction rates during deposition processes or other processes. Using an electron flood gun allows for additional positive or negative sample charging (depending on the electron beam landing energy). Using a laser beam causes additional positive charging via the photoelectric effect. Further process control can be achieved by tuning the electron beam energy or the laser beam wavelength to vary an average depth where the electrons are generated.

In the example of Figures 7 and 8, the substrate W is irradiated in the first step only of the atomic layer deposition. In other embodiments, the irradiation of the selected portion 32 is performed during the second step only or during the first step and the second step. In embodiments not involving immersion liquid, the irradiation of the selected portion 32 in at least one of the two steps may be performed using EUV radiation. Irradiation may additionally be performed in one or more other steps using other forms of irradiation (with or without an immersion liquid), including DUV radiation.

In some embodiments, the method comprises applying a supplementary irradiation to increase a temperature of the support layer 84 during the selective irradiation of the selected portion 32. The supplementary irradiation may be applied before and/or during the selective irradiation. The supplementary irradiation has a spatial resolution that is less fine (of lower resolution) than the selective irradiation. In one embodiment, a lithographic apparatus LA using EUV radiation is used to provide the selective irradiation of the selected portion 32. A patterning device (e.g. a mask) may be used to define the pattern of the selective radiation. This approach achieves high levels of localization, sharp edges, pitch and critical dimension (CD). The supplementary irradiation may also be provided by an EUV radiation system (e.g. without a patterning device and/or with a different, lower resolution, patterning device and/or with defocussing to spread the illumination over a larger area). Alternatively, the supplementary irradiation may be performed using a different radiation system (e.g. a radiation system using longer wavelength radiation, such as infrared radiation). The supplementary irradiation may be referred to as a flood exposure where no patterning device is used or where the irradiation is otherwise sufficiently spread out that the support layer is substantially uniformly illuminated by the supplementary irradiation. The supplementary irradiation may raise the overall average temperature of the support layer 84 such that the temperature increase that needs to be achieved by the selective irradiation is not as high as it would be otherwise. Furthermore, the supplementary irradiation may decrease a temperature difference between the selected portion 32 and surrounding regions thereby reducing the rate of heat conduction away from the selected portion 32. Alternatively or additionally, a substrate heater may be provided that heats the substrate W via a substrate table on which the substrate W is supported.

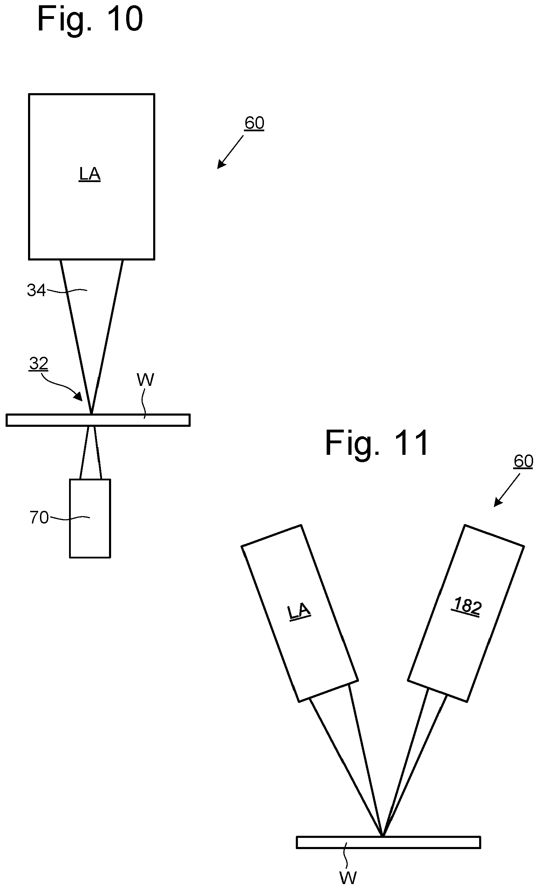

An example apparatus for implementing the selective irradiation and the supplementary irradiation is shown in Figure 10. In the example shown, a lithographic apparatus LA is used to provide the selective irradiation 34 to drive the deposition process. A further radiation system 70 is used to provide the supplementary irradiation. The lithographic apparatus LA and the further radiation system 70 may use different radiation sources. This approach allows each radiation source to be optimised for the respective process it is required to perform (i.e. driving the deposition process or providing the background increase in temperature). In the example of Figure 10, the lithographic apparatus LA and the further radiation system 70 irradiate the substrate W from opposite sides of the substrate W. This approach provides greater flexibility for positioning hardware to implement the respective irradiation processes. In other embodiments, the selective irradiation and the supplementary irradiation are applied from the same side of the substrate W.

In a further arrangement, as exemplified in Figure 11, the selective irradiation of the selected portion 32 to drive the deposition process is performed using EUV radiation applied by a first radiation system LA (e.g. having a wavelength of less than 100nm, optionally in the range of 5-100 nm, optionally within a range of 4 nm to 20 nm, for example 6.7 nm or 13.5 nm) in combination with one or more of the following applied by a second radiation system 182 during the driving of the deposition process: an electron beam; radiation having a wavelength in the range of 100nm to 400nm; and laser radiation. In the example of Figure 11, a EUV lithographic apparatus acts as the first radiation system LA and an e-beam source acts as the second irradiation system 182.

The driving of the deposition process by the EUV radiation often occurs predominantly by the EUV radiation interacting with solid material (e.g. the substrate W or layers formed on the substrate W) to liberate electrons from the solid material and thereby form a plasma. The plasma drives chemical reactions involved with the deposition process. Using an e-beam in combination with the EUV radiation provides a high concentration of electrons and/or further contributes to breaking bonds to create reactive species, thereby promoting faster deposition of material.

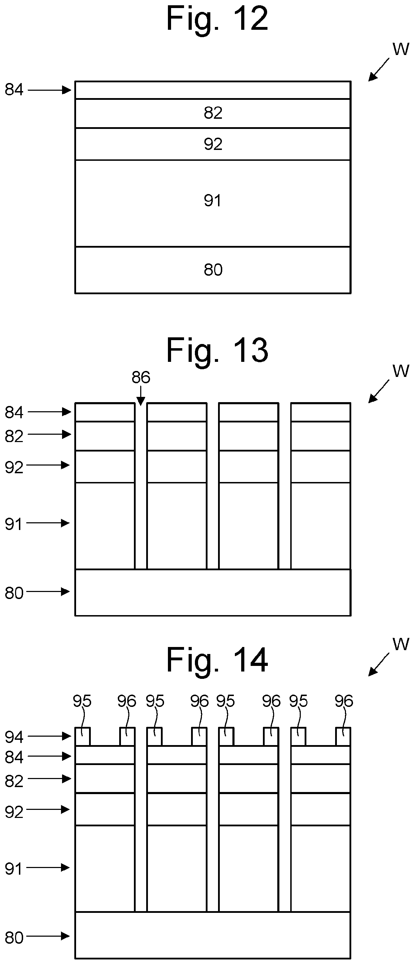

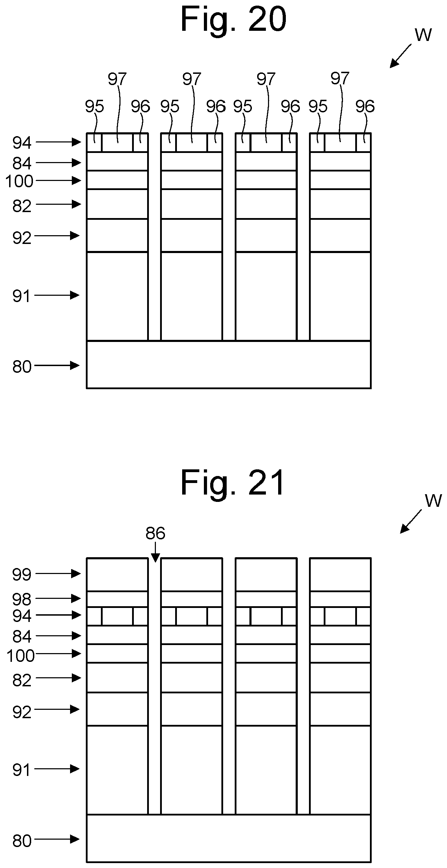

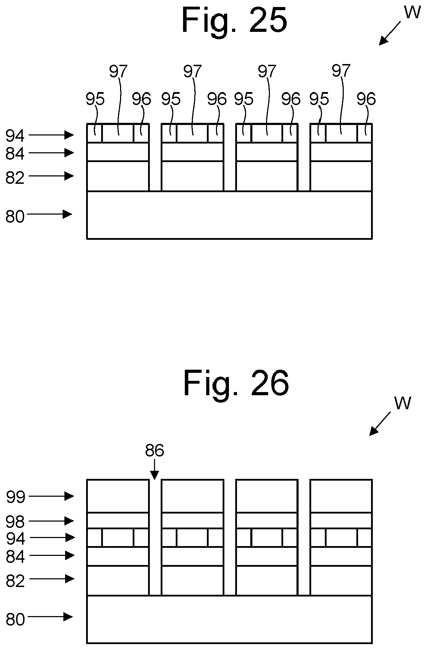

In some embodiments, the sub-units 85 are provided in a sub-unit pattern that is in spatial registration with the pattern defined by the irradiated selected portion 32. For example, the sub-unit pattern and the pattern defined by the irradiated selected portion 32 may both be periodic with the same periodicity in at least one direction within the plane of the substrate W. Features in different unit cells of the sub-unit pattern will thus be consistently aligned with corresponding features in unit cells of the pattern defined by the irradiated selected portion 32. In some embodiments, the sub-units 85 are formed by etching trenches 86 through the support layer 84. The pattern of deposited material defined by the selected portion 32 may then be such that a plurality of isolated portions of the deposited material are provided and each isolated portion is provided on a different one of the sub-units 85 defined by the trenches 86. Each of the isolated portions of deposited material may be equal to or smaller in area than the sub-unit 85 on which the isolated portion is provided. The trenches 86 may thus define island-like sub-units 85 in the support layer 84 and a distinct isolated portion of the deposited material may be deposited on each of the island-like sub-units 85. A spatial resolution of the selective irradiation must be fine enough to promote deposition locally on regions that are the same size or smaller than the sub-units 85. These concepts are exemplified by embodiments described below with reference to Figures 12-31 and the exemplary application to manufacturing 2D-FETs.

Figures 12-26 depict example process flows for forming 2D-FETs using the methods described above. Corresponding process flows may be used to form devices in which the deposited two-dimensional material performs other functions. The two-dimensional material may, for example, be deposited in a trench (e.g. without source/drain or gate dielectric) to operate as an interconnect.

Figure 12 depicts a first stage in an example process flow for forming a 2D-FET. A substrate W comprising a layered structure is provided. The layered structure comprises a base layer 80 (e.g. a silicon wafer), a support layer 84 and a thermally insulating layer 82. The layered structure may take any of the forms discussed above with reference to Figure 6. In the example shown, the layered structure further comprises a lower dielectric layer 92. The lower dielectric layer 92 may be configured to function as a bottom gate dielectric of a 2D-FET. In one arrangement, the lower dielectric layer 92 comprises, consists essentially of, or consists of, $HfO_2$. The layered structure further comprises a spacer layer 91. The spacer layer 91 may comprise, consist essentially of, or consist of, $SiO_2$ for example. The spacer layer 91 may have the same composition as the support layer 84. Various different thicknesses may be selected for each of the layers of the layered structure. In one arrangement: the spacer layer 91 has a thickness of 40nm and comprises $SiO_2$; the lower dielectric layer 92 has a thickness of 10nm and comprises $HfO_2$; and the support layer 84 has a thickness of 5nm and comprises $SiO_2$.

Figure 13 depicts a stage after processing of the arrangement of Figure 12 to etch trenches 86 through the support layer 84. In this example, the trenches 86 extend through all of the layers above the base layer 80. The trenches 86 segment the support layer 84 to form sub-units 85 in a sub-unit pattern. The sub-unit pattern is periodic in a horizontal direction in the plane of the page and in a direction into the page (not shown).

Figure 14 depicts a stage after processing of the arrangement of Figure 13 to provide a source material unit 95 and drain material unit 96 in a device layer 94 on each sub-unit 85 of the support layer 84. The source material unit 95 and drain material unit 96 may be formed from any material that is suitable for functioning as source and/or drain in a 2D-FET, such as Ti, TiN and/or W. The source material unit 95 and drain material unit 96 may be formed by conventional lithography processing (e.g. resist coating, lithography, etching, resisting stripping, etc.) or using EUV induced deposition (without resist). If conventional lithographic processing is used an efficient cleaning process will be desirable to limit the presence of contaminations at the edge interfacing source/drain electrodes.

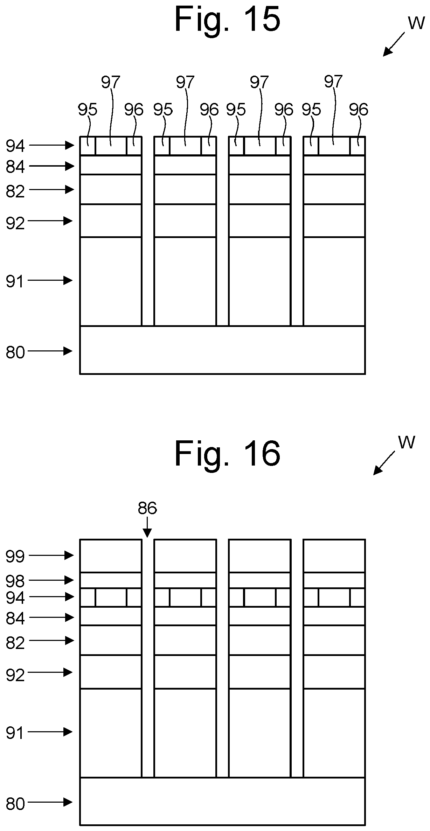

Figure 15 depicts a stage after processing of the arrangement of Figure 14 to deposit a region 97 of two-dimensional material in the space between the source material unit 95 and drain material unit 96 of each sub-unit 85. The two-dimensional material constitutes a patterned layer of material that may be formed using any of the methods of forming a patterned layer of material described herein. The two-dimensional material may thus be deposited by selectively irradiating a selected portion 32 of the support layer 84 during a deposition process. In this case, the selected portion 32, and the resulting pattern of deposited material, comprises a plurality of isolated portions of deposited material. Each isolated portion is provided on a different on one of the sub-units 85. The region 97 on each sub-unit 85 is an example of such an isolated portion. The sub-unit pattern is in spatial registration with the pattern defined by the irradiated selected portion 32. Each sub-unit 85 is spatially aligned with one of the regions 97 of two-dimensional material forming part of the pattern defined by the irradiated selected portion 32. The pattern defined by the irradiated selected portion 32 is periodic in the horizontal direction in the plane of the page with the same periodicity as the sub-unit pattern. The regions 97 corresponding to the isolated portions of deposited material each form an identical component of a different electronic device to be manufactured (in this example, they each form the channel of a 2D-FET). The two-dimensional material may comprise any semiconductor two-dimensional material suitable for use as a transistor channel, such as a TMD (e.g. $WS_2$, $MoS_2$, $WSe_2$, $MoSe_2$), an MXene, graphene or antimonene.

Figure 16 depicts a stage after processing of the arrangement of Figure 15 to provide an upper dielectric layer 99. The upper dielectric layer 99 may be configured to function as a top gate dielectric of a 2D-FET. In the case of nanosheet and gate-all-around (GAA) the two-dimensional material 2D layer may be fully wrapped with gate dielectric. In one arrangement, the upper dielectric layer 99 comprises, consists essentially of, or consists of, $HfO_2$. The layered structure further comprises a spacer layer 98 between the upper dielectric layer 99 and the device layer 94. The spacer layer 98 may comprise, consist essentially of, or consist of, $SiO_2$ for example. The spacer layer 98 may have the same composition as the support layer 84.

The process flow of Figures 12-16 is desirable because the thermally insulating layer 82 is provided directly below the support layer 84. This configuration favours localized temperature rises in the support layer 84. However, it is also possible to provide a process flow in which the stacking order of the thermally insulating layer 82 and the lower dielectric layer 92 (functioning as bottom gate dielectric) is reversed. The thermally insulating layer 82 would thus be below the lower dielectric layer 92 in such a process flow. All other elements of the process flow may take any of the forms described above with reference to Figures 12-16.

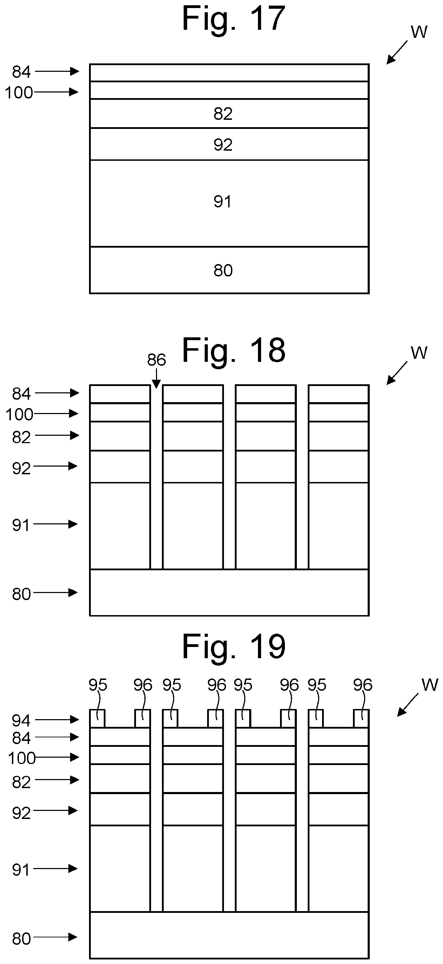

Figures 17-21 depict a variation on the process flow of Figures 12-16 in which an additional underlayer 100 is provided beneath the support layer 84. This underlayer 100 may be provided between the thermally insulating layer 82 and the support layer 84 and/or in direct contact with the support layer 84. All other elements of the process flow may take any of the forms described above with reference to Figures 12-16. The thermally insulating layer 82 could be provided below the lower dielectric layer 92 as an alternative. The underlayer 100 may be configured to absorb substantially all radiation penetrating through the support layer 84 during the selective irradiation (i.e. all or most of the remnant photons transmitted from the support layer 84) and thereby contribute to retaining heat energy derived from the irradiation above the thermally insulating layer 82. The underlayer 100 may comprise one or more elements having a high atomic absorption cross-section, for example higher than about $0.5 \times 10^7 cm^2/mol$, preferably higher than $0.75 \times 10^7 cm^2/mol$, preferably higher than about $1.0 \times 10^7 cm^2/mol$. In some embodiments, the underlayer 100 comprises one or more of the following: $In_2O_3$, ITO, $SnO_2$, Sn. The thickness of the underlayer 100 may be selected to achieve a desired amount of absorption. For example, underlayers made of ITO with thicknesses of 10nm, 20nm, 30nm and 40nm roughly absorb 47%, 72%, 85% and 92% of EUV photons respectively. The underlayer 100 may be particularly useful because the material of the support layer 84 is desirably selected to be suitable for growth of the two-dimensional material. The support layer 84 may not be suitable for absorbing all of the incoming photons associated with the irradiation. A portion of the photons may be transmitted to layers beneath the support layer 84. The provision of the underlayer 100 allows all or most of these remnant photons to be absorbed above the thermally insulating layer 82 where the resulting heat can contribute to the local driving of the deposition process.

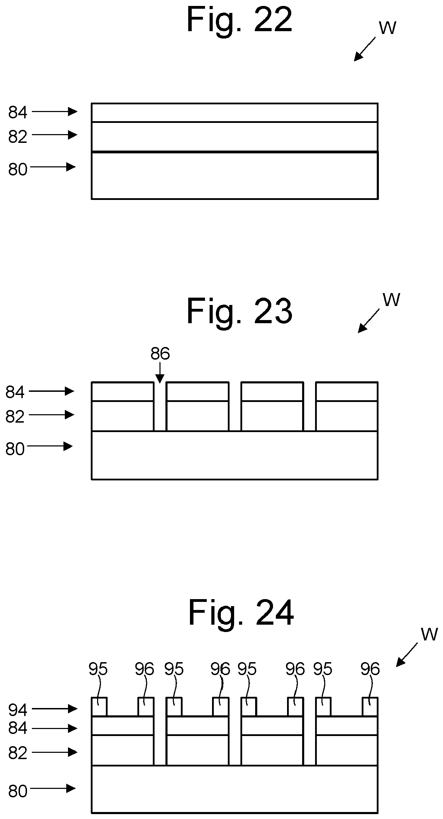

Figures 22-26 depict a variation on the process flows described above in which the spacer layer 91 and the lower dielectric layer 92 are omitted. All other elements of the process flow may take any of the forms described above with reference to Figures 12-16 and Figures 17-21.

The embodiments may further be described using the following clauses:

1. A method of forming a patterned layer of material, comprising:

providing a substrate having a layered structure, the layered structure comprising a base layer, a support layer, and a thermally insulating layer, wherein:

the thermally insulating layer has a lower thermal conductivity than the support layer;
the support layer comprises a plurality of sub-units that are thermally insulated from each other within a plane of the support layer; and
the method comprises selectively irradiating a selected portion of the support layer during a deposition process, the irradiation being such as to locally drive the deposition process in the selected portion and thereby form a layer of deposited material in a pattern defined by the selected portion.

2. The method of clause 1, wherein the layered structure further comprises an underlayer between the support layer and the thermally insulating layer, the underlayer being configured to absorb substantially all radiation penetrating through the support layer during the selective irradiation.

3. The method of any preceding clause, wherein the layer of deposited material comprises a two-dimensional material, preferably a monolayer.

4. The method of any preceding clause, wherein the thermally insulating layer comprises a multilayer stack comprising layers of two-dimensional material.

5. The method of clause 4, wherein at least two adjacent layers of two-dimensional material in the thermally insulating layer have different compositions relative to each other.

6. The method of clause 4 or 5, wherein the layers of two-dimensional material in the thermally insulating layer comprise one or more layers of the following: graphene; $WSe_2$; $MoS_2$; $\alpha$-selenene; $\alpha$-tellurene.

7. The method of any preceding clause, wherein the sub-units are provided in a sub-unit pattern that is in spatial registration with the pattern defined by the irradiated selected portion.

8. The method of clause 7, wherein the sub-unit pattern and the pattern defined by the irradiated selected portion are both periodic with the same periodicity in at least one direction within the plane of the substrate.

9. The method of any preceding clause, further comprising forming the sub-units in the support layer by etching trenches through the support layer.

10. The method of any preceding clause, wherein the pattern of deposited material comprises a plurality of isolated portions of deposited material, each isolated portion being provided on a different one of the sub-units.

11. The method of clause 10, wherein each of the isolated portions of deposited material is equal to or smaller in area than the sub-unit on which the isolated portion is provided.

12. The method of clause 10 or 11, wherein each of the isolated portions of deposited material form an identical component of a different electronic device to be manufactured.

13. The method of clause 12, wherein the isolated portions of deposited material form channels of electronic devices.

14. The method of clause 12 or 13, wherein the electronic device to be manufactured comprises a 2D-FET.

15. The method of any preceding clause, further comprising applying a supplementary irradiation to increase a temperature of the support layer during the selective irradiation of the selected portion, wherein the supplementary irradiation has a spatial resolution that is less fine than the selective irradiation.

16. The method of clause 15, wherein the selective irradiation and the supplementary irradiation are performed using different radiation sources.

17. The method of any preceding clause, wherein the selective irradiation is performed using electromagnetic radiation having a wavelength of less than 100nm.

18. The method of any preceding clause, wherein the support layer comprises one or more of the following: $Al_2O_3$; $SiO_2$; $HfO_2$; Sn; $SnO_2$; $In_2O_3$; ITO.

19. The method of any preceding clause, wherein the deposition process comprises one or more of the following: atomic layer deposition; chemical vapor deposition; plasma-enhanced chemical vapor deposition; epitaxy; sputtering; and electron beam-induced deposition.

20. The method of any preceding clause, wherein the layer of deposited material comprises one or more of the following: graphene; antimonene; an MXene; hexagonal boron nitride; a transition metal dichalcogenide.

21. The method of any preceding clause, wherein a lithographic apparatus is used to provide the selective irradiation by projecting a patterned radiation beam from a patterning device onto the substrate.

22. A method of forming a semiconductor device, comprising using the method of any preceding clause to form at least one layer in the device.

In any of the above-described methods of forming a patterned layer of material, the patterned layer of material can comprise final material that will be present in the device being manufactured (e.g. an IC device). The final material may, for example, comprise a two-dimensional material, such as one or more of the following: graphene, hexagonal boron nitride (hBN), and transition metal dichalcogenides (TMD). Alternatively or additionally, the patterned layer of material can comprise an auxiliary pattern that will contribute functionally to one or more subsequent manufacturing steps. In an embodiment, the auxiliary material functions as a hard mask (when formed from amorphous C for example). In an embodiment, the auxiliary material functions as a material enhancing photoelectron yield (when comprising Sn, In and/or one or more of their compounds for example). In an embodiment, the auxiliary material functions as a precursor and/or co-reactant and/or catalyst (e.g. metals and their compounds) for one or more subsequent deposition steps.

**Claims**

1. A method of forming a patterned layer of material, comprising:
   providing a substrate having a layered structure, the layered structure comprising a base layer, a support layer, and a thermally insulating layer, wherein:

   the thermally insulating layer has a lower thermal conductivity than the support layer;
   the support layer comprises a plurality of sub-units that are thermally insulated from each other within a plane of the support layer; and
   the method comprises selectively irradiating a selected portion of the support layer during a deposition process, the irradiation being such as to locally drive the deposition process in the selected portion and thereby form a layer of deposited material in a pattern defined by the selected portion.

2. The method of claim 1, wherein the layered structure further comprises an underlayer between the support layer and the thermally insulating layer, the underlayer being configured to absorb substantially all radiation penetrating through the support layer during the selective irradiation.

3. The method of any preceding claim, wherein the layer of deposited material comprises a two-dimensional material, preferably a monolayer.

4. The method of any preceding claim, wherein the thermally insulating layer comprises a multilayer stack comprising layers of two-dimensional material, wherein at least two adjacent layers of two-dimensional material in the thermally insulating layer have different compositions relative to each other.

5. The method of claim 4, wherein the layers of two-dimensional material in the thermally insulating layer comprise one or more layers of the following: graphene; $WSe_2$; $MoS_2$; $\alpha$-selenene; $\alpha$-tellurene.

6. The method of any preceding claim, wherein the sub-units are provided in a sub-unit pattern that is in spatial registration with the pattern defined by the irradiated selected portion.

7. The method of any preceding claim, further comprising forming the sub-units in the support layer by etching trenches through the support layer.

8. The method of any preceding claim, wherein the pattern of deposited material comprises a plurality of isolated portions of deposited material, each isolated portion being provided on a different one of the sub-units.

9. The method of claim 8, wherein each of the isolated portions of deposited material form an identical component of a different electronic device to be manufactured.

10. The method of claim 9, wherein the isolated portions of deposited material form channels of electronic devices.

11. The method of any preceding claim, further comprising applying a supplementary irradiation to increase a temperature of the support layer during the selective irradiation of the selected portion, wherein the supplementary irradiation has a spatial resolution that is less fine than the selective irradiation.

12. The method of any preceding claim, wherein the selective irradiation is performed using electromagnetic radiation having a wavelength of less than 100nm, and wherein the support layer comprises one or more of the following: $Al_2O_3$; $SiO_2$; $HfO_2$; Sn; $SnO_2$; $In_2O_3$; ITO.

13. The method of any preceding claim, wherein the deposition process comprises one or more of the following: atomic layer deposition; chemical vapor deposition; plasma-enhanced chemical vapor deposition; epitaxy; sputtering; and electron beam-induced deposition, and wherein the layer of deposited material comprises one or more of the following: graphene; antimonene; an MXene; hexagonal boron nitride; a transition metal dichalcogenide.

14. The method of any preceding claim, wherein a lithographic apparatus is used to provide the selective irradiation by projecting a patterned radiation beam from a patterning device onto the substrate.

15. A method of forming a semiconductor device, comprising using the method of any preceding claim to form at least one layer in the device.

# Fig. 1

# Fig. 2

# Fig. 3

## Fig. 4

## Fig. 5

# Fig. 6

# Fig. 7

# Fig. 8

# Fig. 9

## Fig. 10

LA

60

34

32

W

70

## Fig. 11

60

LA

182

W

## Fig. 12

W

84 →

| 82 |
| 92 |
| 91 |
| 80 |

## Fig. 13

86

W

84 →
82 →
92 →
91 →
80 →

## Fig. 14

W

95 96 95 96 95 96 95 96

94 →
84 →
82 →
92 →
91 →
80 →

# Fig. 15

W

97      97      97      97

95      96  95      96  95      96  95      96

94 →

84 →

82 →

92 →

91 →

80 →

# Fig. 16

W

86

99 →

98 →
94 →

84 →

82 →

92 →

91 →

80 →

# Fig. 17

84 →

100 →

W ↙

| 82 |
| 92 |
| 91 |
| 80 |

# Fig. 18

86 ↓

84 →
100 →
82 →
92 →
91 →
80 →

W ↙

# Fig. 19

95  96  95  96  95  96  95  96

94 →
84 →
100 →
82 →
92 →
91 →
80 →

W ↙

# Fig. 20

# Fig. 21

# Fig. 22

W

84 →

82 →

80 →

# Fig. 23

W

86

84 →

82 →

80 →

# Fig. 24

W

95  96  95  96  95  96  95  96

94 →

84 →

82 →

80 →

# Fig. 25

W

97  97  97  97

95  96  95  96  95  96  95  96

94
84

82

80

# Fig. 26

W

86

99
98
94
84

82

80

Europäisches
Patentamt
European
Patent Office
Office européen
des brevets

**EUROPEAN SEARCH REPORT**

Application Number

EP 20 20 8461

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/256418 A1 (CHANG SHU-HAO [TW] ET AL) 7 September 2017 (2017-09-07) * paragraph [0013] - paragraph [0023]; figures 1, 2A, 2B, 2C * | 1-15 | INV. C23C16/04 C23C16/48 G03F7/004 G03F7/16 H01L21/02 H01L21/027 H01L29/739 |
| X | US 2019/348292 A1 (DUTTA ASHIM [US] ET AL) 14 November 2019 (2019-11-14) * paragraph [0024] - paragraph [0038]; figure 1 * | 1-15 | |
| X,D | WO 2019/166318 A1 (ASML NETHERLANDS BV [NL]) 6 September 2019 (2019-09-06) * claims; figures * | 1-15 | |
| X | EP 3 534 211 A1 (ASML NETHERLANDS BV [NL]) 4 September 2019 (2019-09-04) * claims; figures * | 1-15 | |

TECHNICAL FIELDS
SEARCHED    (IPC)

C23C
G03F
H01L

The present search report has been drawn up for all claims

| Place of search | Date of completion of the search | Examiner |
|---|---|---|
| The Hague | 23 April 2021 | Engelen, Karen |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 20 8461

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2021

| Patent document cited in search report | | | Publication date | Patent family member(s) | | | Publication date |
|---|---|---|---|---|---|---|---|
| US 2017256418 | A1 | | 07-09-2017 | CN<br>TW<br>US<br>US | 107153326<br>201732446<br>2017256418<br>2018314167 | A<br>A<br>A1<br>A1 | 12-09-2017<br>16-09-2017<br>07-09-2017<br>01-11-2018 |
| US 2019348292 | A1 | | 14-11-2019 | NONE | | | |
| WO 2019166318 | A1 | | 06-09-2019 | CN<br>EP<br>KR<br>TW<br>US<br>WO | 111837074<br>3759550<br>20200118119<br>201944169<br>2021079519<br>2019166318 | A<br>A1<br>A<br>A<br>A1<br>A1 | 27-10-2020<br>06-01-2021<br>14-10-2020<br>16-11-2019<br>18-03-2021<br>06-09-2019 |
| EP 3534211 | A1 | | 04-09-2019 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- WO 2019166318 A
- WO 2020207759 A
- EP 20160615

**Non-patent literature cited in the description**

- **ZHENGWEI ZHANG ; PENG CHEN ; XIANGDONG YANG ; YUAN LIU ; HUIFANG MA ; JIA LI ; BEI ZHAO ; JUN LUO ; XIDONG DUAN ; XIANGFENG DUAN.** Ultrafast growth of large single crystals of monolayer WS2 and WSe. *National Science Review,* April 2020, vol. 7 (4), 737-744

- **WEIDONG ZHENG ; BIN HUANG ; YEE KAN KOH.** Ultralow Thermal Conductivity and Thermal Diffusivity of Graphene/Metal Heterostructures through Scarcity of Low-Energy Modes in Graphene. *ACS Applied Materials & Interfaces,* 2020, vol. 12 (8), 9572-9579